# EUROPÄISCHE PATENTSCHRIFT

(11) **EP 2 151 151 B1**
(45) Veröffentlichungstag und Bekanntmachung des Hinweises auf die Patenterteilung: **06.10.2010**
(21) Anmeldenummer: 08759841.3
(22) Anmeldetag: 21.05.2008
(51) Int. Cl.: H05K 7/14

(54) **CODIERUNG, INSBESONDERE FÜR EINE EINSCHUBANORDNUNG EINES ELEKTRISCHEN SCHALTFELDES**
CODING SYSTEM, ESPECIALLY FOR AN INSERT/MODULE UNIT OF AN ELECTRIC SWITCHBOARD
CODAGE, NOTAMMENT POUR UN ENSEMBLE ENFICHABLE D'UN TABLEAU DE DISTRIBUTION ÉLECTRIQUE

(30) Priorität: 30.05.2007 DE 102007025458
(43) Veröffentlichungstag der Anmeldung: 10.02.2010
(73) Patentinhaber: Siemens Aktiengesellschaft, 80333 München (DE)
(72) Erfinder: HIRSCHFELD, Stefan, 04207 Leipzig (DE)
(86) Internationale Anmeldenummer: PCT/EP2008/056237
(87) Internationale Veröffentlichungsnummer: WO 2008/151909

(56) Entgegenhaltungen:
- EP-A- 0 528 735
- US-A- 4 595 250

## Beschreibung

Die Erfindung betrifft die konstruktive Gestaltung einer Codierung für ein erstes Bauteil (beispielsweise für ein Einschubfach eines elektrischen Schaltfeldes), dem ein zweites Bauteil (beispielsweise ein Einschub) zuzuordnen ist.

Aus der Druckschrift US 4,595,250 ist eine codierte Verbindung zwischen einem Gehäuses einer gedruckten Leiterplatte und einem Gehäuses einer elektronischen Steckkarte bekannt, bei der die gedruckte Leiterplatte und das Gehäuse der elektronischen Steckkarte mit einander zugeordneten gattungsgemäßen Codierungen versehen sind.

So besteht beispielsweise die Codierung des Gehäuses der gedruckten Leiterplatte aus mehreren Codieranordnungen. Jede dieser Codieranordnungen weist ein Positioniermittel in Form eines Ansatzes auf, der sich in einem vorgegebenen Abstand parallel zu einer Drehachse erstreckt und der zu einem Positioniermittel des Gehäuses der gedruckten Leiterplatte in Form einer Perforation derart komplementär ist, dass die Codieranordnung an dem Gehäuse der gedruckten Leiterplatte in mehreren verschiedenen, zu der Drehachse rotationssymmetrischen Stellungen positionierbar ist. Zur Schaffung der Codierten Verbindung mit dem Gehäuse der elektronischen Steckkarte weist jede der Codieranordnungen der gedruckten Leiterplatte ein Codiermittel in Form eines Fingers auf. Dieser Finger ist zu einem Codiermittel der elektronischen Steckkarte in Form einer Öffnung komplementär und befindet sich in einer korrespondierenden Stellung zu dieser Öffnung.

Auf der anderen Seite besteht die Codierung der elektronischen Steckkarte ebenfalls aus mehreren Codieranordnungen. Jede dieser Codieranordnungen weist drei Positioniermittel in Form von Ansätzen auf, die sich ebenfalls in einem vorgegebenen Abstand parallel zu einer Drehachse erstrecken und die zu einem Positioniermittel der elektronischen Steckkarte derart komplementär sind, dass die Codieranordnung an der elektronischen Steckkarte in mehreren verschiedenen, zu der Drehachse rotationssymmetrischen Stellungen positionierbar ist. Hierzu ist das Positioniermittel des Gehäuses der elektronischen Steckkarte ebenfalls in Form einer Perforation ausgebildet, dessen Radius dem vorgegebenen Abstand entspricht. Zur Schaffung der codierten Verbindung mit der gedruckten Leiterplatte greifen - wie bereits beschrieben - die Finger der Codieranordnungen der gedruckten Leiterplatte in zugeordnete Öffnungen der Codieranordnungen der elektronischen Steckkarte.

Ausgehend von einer Codierung mit den Merkmalen des Oberbegriffes des Patentanspruches 1 (US 4,595,250) - also ausgehend von einer Codierung mit zumindest einer Codieranordnung, bei der die Codieranordnung ein Positioniermittel aufweist, dass zu einem Positioniermittel des ersten Bauteils derart komplementär ist, dass die zumindest eine Codieranordnung an dem ersten Bauteil in einer aus zumindest zwei verschiedenen, zu einer Drehachse rotationssymmetrischen Stellungen an dem ersten Bauteil positionierbar ist, und bei der die Codieranordnung zur Schaffung einer codierten Verbindung mit dem zweiten Bauteil zumindest ein Codiermittel aufweist, das durch seine Position den Code der Codieranordnung bestimmt, das zu einem Codiermittel des zweiten Bauteils, dessen Position den Code des zweiten Bauteils bestimmt, komplementär ausgebildet ist und das bei konkordantem Codes der beiden Bauteile eine korrespondierende Stellung zu dem Codiermittel des zweiten Bauteils inne hat - liegt der Erfindung die Aufgabe zu Grunde, auf einfache Weise die Anzahl der Codiervariationen zu erhöhen.

Diese Aufgabe wird gemäß der Erfindung dadurch gelöst, dass die Codieranordnung aus zumindest einem mit dem Positioniermittel versehenen ersten und einem zweiten Codierelement besteht, wobei die beiden Codierelemente Eingriffmittel aufweisen, die derart zueinander komplementär sind, dass die beiden Codierelemente in einer aus zumindest zwei verschiedenen, zu der Drehachse rotationssymmetrischen Stellungen in Eingriff miteinander stehen, und wobei jeweils zumindest eines der Codiermittel sowohl an dem ersten und als auch an dem zweiten Codierelement vorgesehen ist. - Selbst bei einfachster Ausgestaltung der erfindungsgemäßen Codierung, bei der das zweite Codierelement in nur zwei verschiedenen Stellungen in Eingriff mit dem ersten Codierelement gebracht werden kann, ist gegenüber der aus der US 4,595,250 bekannten Codierung schon die doppelte Anzahl der Codiermöglichkeiten auf kleinem Bauraum realisiert.

In bevorzugter Ausgestaltung der neuen Codierung ist vorgesehen, dass das erstes Codierelement als Eingriffmittel eine zentrische Aussparung aufweist, die mit zumindest zwei Ausbuchtungen versehen ist und das zweite Codierelement in die zentrische Aussparung einsetzbar ist, und als komplementäres Eingriffmittel eine Nase aufweist, die in eine der Ausbuchtungen eingreift. - Somit ist das zweite Codierelement in dem ersten Codierelement versenkbar, so dass im Vergleich zu der aus der US 4,595,250 bekannten Codierung in Richtung der Drehachse kein zusätzlicher Bauraum zur Unterbringung des zweiten Codierelementes erforderlich ist.

Eine besonders große Anzahl an Codiervariationen ist bei der neuen Codierung realisierbar, wenn zwei oder mehrere der Codieranordnungen vorgesehen sind.

Eine mechanisch einfach realisierbare Ausgestaltungen der neuen Codierung sieht vor, dass als Positioniermittel zumindest ein Stift dient, der sich in einem vorgegebenen ersten Abstand parallel zur Drehachse erstreckt und dem als komplementäres Positioniermittel des ersten Bauteils ein auf einer Kreisbahn angeordnetes Lochmuster zugeordnet ist, wobei der Radius der Kreisbahn dem vorgegebenen ersten Abstand entspricht.

Eine weitere, mechanisch ebenfalls einfach realisierbare Ausgestaltung sieht vor, dass als Codiermittel an den Codierelementen zumindest ein von der Drehachse beabstandeter Zapfen und/oder zumindest eine von der Drehachse beabstandete Aussparung vorgesehen sind. - Die einander zuzuordnenden beiden Bauteile können dabei beispielsweise mit identischen Codierungen versehen werden, wenn an jedem der Codierelemente ein solcher Zapfen und eine solche Aussparung vorgesehen sind, die sich gegenüber liegen, und bei denen der Außendurchmesser der Zapfen kleiner als der Innendurchmesser der Ausnehmungen ist.

Wenn die beiden Codierelemente Anschlagflächen aufweisen, mittels derer sie in Richtung der Drehachse aneinander anschlagen, dann können sie auf einfache Weise gemeinsam mit nur einem Befestigungsmittel am zugeordneten Bauteil befestigt werden. Dabei können die Codierelemente zur Aufnahme dieses Befestigungsmittels in Richtung der Drehachse mit einer Durchgangsbohrung versehnen sein. Um auch hier den erforderlichen Bauraum in Richtung der Drehachse so gering wie möglich zu halten ist es vorteilhaft, wenn das Codierelement, dessen Anschlagfläche in Einbaulage dem ersten Bauteil zugewandt ist, mit einer Senkung zur Aufnahme eines Anschlagkopfes des Befestigungsmittels versehen ist.

Eine weitere bevorzugte Ausgestaltung der neuen Codierung sieht vor, dass das erste, mit dem Positioniermittel versehene Codierelement zur visuellen Anzeige der ausgewählten Stellung am ersten Bauelement ein erstes Anzeigemittel und dass das zweite Codierelement zur visuellen Anzeige der ausgewählten Stellung gegenüber dem ersten Codierelement ein zweites Anzeigemittel aufweist.

Dabei kann das erste Codiermittel mit dem zweiten Anzeigemittel zugeordneten Kennzeichen - beispielsweise in Form von Buchstaben oder Zahlen - versehen sein, wobei das zweite Anzeigemittel zur visuellen Anzeige der ausgewählten Stellung des zweiten Codierelementes auf eines dieser Kennzeichen weist. Dabei kann aber auch eines der Codiermittel der Codierelemente als Anzeigemittel dienen.

Die neue Codierung ist mit Vorteil in Einschubanordnung eines elektrischen Schaltfeldes einsetzbar, um einen Einschub einem vorgegebenen Einschubfach zuzuordnen.

In der Praxis wurden hierzu bisher mehrere Schrauben verwendet, die unter zeitlich hohem Montageaufwand in bestimmten konkordanten Mustern an gegenüberliegenden Seiten des Einschubfaches und des Einschubes angeschraubt wurden.

Die erfindungsgemäße Codierung kann an dem Einschubfach und/oder an dem Einschub ausgebildet sein. - Ist die neue Codierung beispielsweise nur am Einschubfach vorgesehen, so kann der zuzuordnende Einschub auch unmittelbar mit den korrespondierenden Codiermitteln versehen sein.

Das Einschubfach und/oder der Einschub können mit Kennzeichen versehen sein, die dem ersten Anzeigemittel zugeordnet sind wobei das erste Anzeigemittel zur visuellen Anzeige der ausgewählten Stellung des ersten Codierelementes auf eines der Kennzeichen weist. Auch hier sind als Kennzeichen insbesondere Buchstaben oder Zahlen vorgesehen.

Die neue Codierung wird im Folgenden anhand der in den Figuren 1 bis 21 beschriebenen Ausführungsformen näher erläutert.

Dabei zeigen:
- Figur 1: ein elektrisches Schaltfeld einer Schaltanlage mit einer Einschubanordnung, die aus einem Einschubfach und einem Einschub besteht, wobei sowohl das Ein- schubfach als auch der Einschub jeweils mit einer ersten Ausführungsform der erfindungsgemäßen Codie- rung versehen sind, die jeweils drei Codieranord- nungen aufweisen.
- Figur 2: eine an einer Rückwand des Einschubfaches befestig- te Codieranordnung der Codierung des Einschubfaches gemäß der Figur 1,
- Figur 3: eine weitere Ansicht der Codieranordnung gemäß der Figur 2,
- Figur 4: eine Ansicht der Rückwand des Einschubfaches von der dem Einschub abgewandten Seite,
- Figur 5: eine Vorderansicht auf die Codieranordnung gemäß der Figur 2,
- Figur 6: eine Vorderansicht auf eine der Codieranordnungen des Einschubes gemäß der Figur 1 mit einem Code, der zu dem Code der Codieranordnung des Einschubfa- ches gemäß der Figuren 2 bis 5 konkordant ist,
- Figuren 7 und 8: die Codieranordnungen gemäß der Figuren 5 bzw. 6 mit anderen Codes, die ebenfalls zueinander konkordant sind,
- Figur 9: die Codieranordnungen gemäß der Figuren 5 und 6 in einer getrennten ersten Stellung,
- Figur 10: die Codieranordnungen gemäß der Figuren 5 und 6 in einer mechanisch verbundenen zweiten Stellung,
- Figur 11: die Codieranordnungen gemäß der Figuren 5 und 6, die aufgrund nicht konkordanter Codes mechanisch nicht verbindbar sind,
- Figuren 12 bis 15: eine zweite Ausführungsform der neuen Co- dierung, bei der konkordante Codes durch identische Kennzeichen visualisiert sind,
- Figuren 16 bis 21: eine dritte Ausführungsform der neuen Co- dieranordnungen, bei der ebenfalls konkordante Co- des durch identische Kennzeichen visualisiert sind.

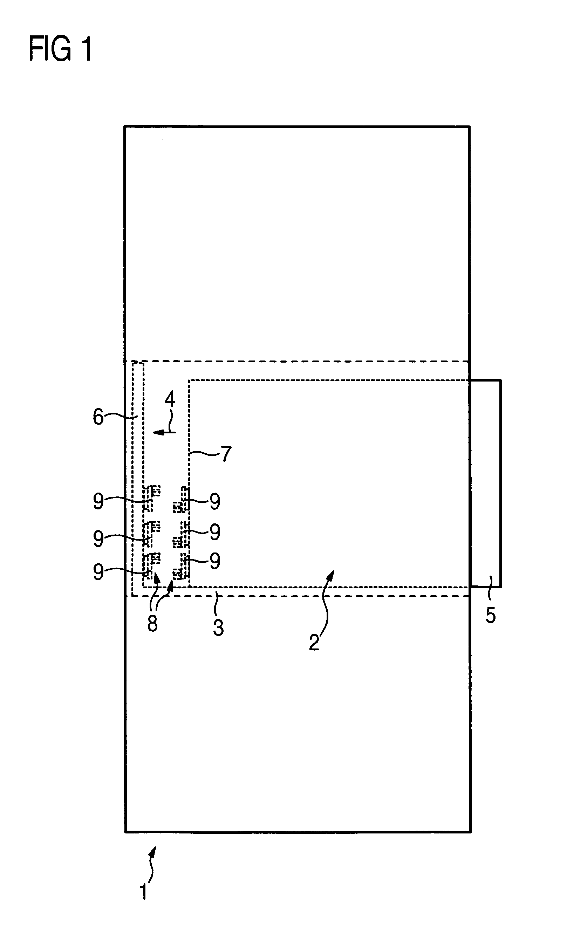

Die Figur 1 zeigt schematisch ein elektrisches Schaltfeld 1 einer Schaltanlage mit einer Einschubanordnung 2, die aus einem Einschubfach 3 und einem in der Schubrichtung 4 in das Einschubfach einschiebbaren Einschub 5 besteht. Dabei sind einerseits die dem Einschub 5 zugewandte Seite einer Einschubfach-Wand 6 und andererseits die dem Einschubfach 3 zugewandte Seite einer Einschub-Wand 7 mit einander zugeordneten Codierungen 8 versehen.

Beide Codierungen 8 bestehen im gezeigten Beispiel jeweils aus drei Codieranordnungen 9. Es können jedoch auch nur eine, zwei oder auch mehr als drei der Codieranordnungen 9 an dem Einschubfach und an dem Einschub vorgesehen sein.

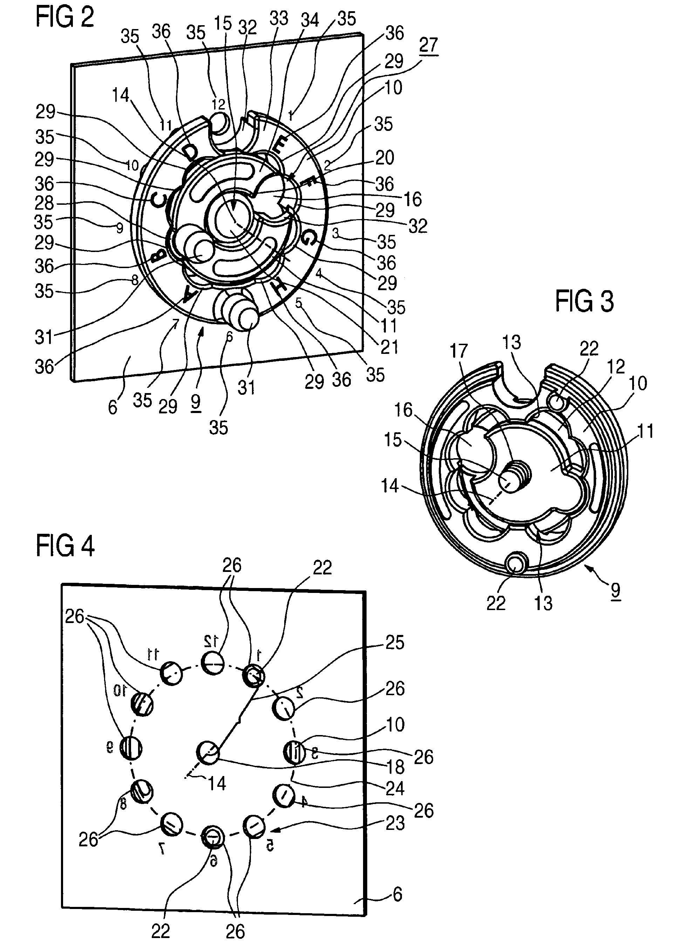

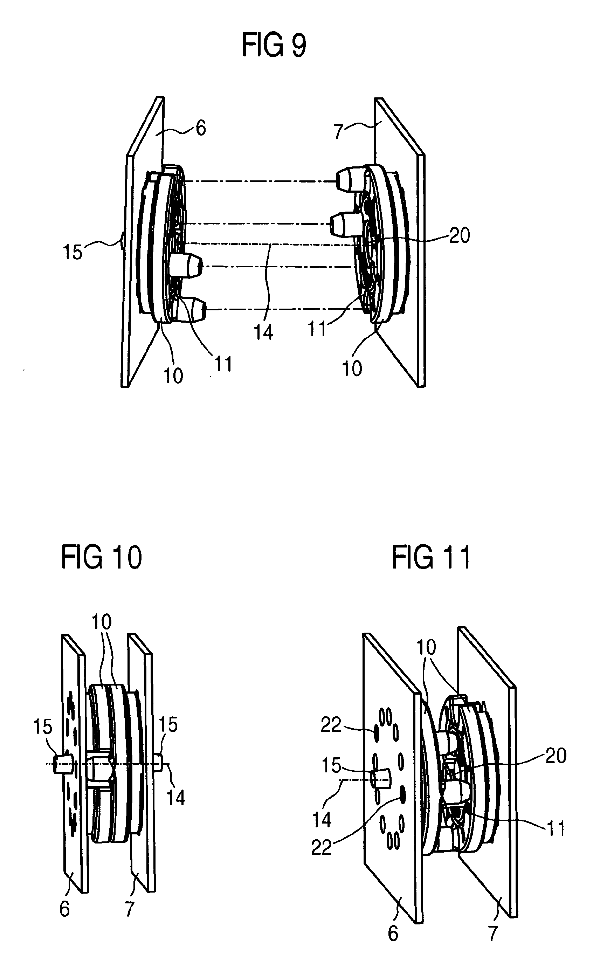

Die Figur 2 zeigt eine der Codieranordnungen 9, die an der Einschubfach-Wand 6 angeordnet ist. Diese Codieranordnung 9 besteht aus zwei Codierelementen 10 und 11, in Form eines äußeren Codierringes und einer inneren Codierscheibe. Dabei wird das zweite Codierelement 11 in Form der Codierscheibe in das erste Codierelement 10 in Form des Codierringes eingesetzt. Die Figuren 9 bis 11 zeigen, wie eine identisch ausgebildete Codieranordnung an der Einschub-Wand 7 des Einschubes befestigt ist.

Bei jeder der gezeigten Codieranordnungen weisen die beiden Codierelemente erste Anschlagflächen 12 bzw. 13 auf, mittels derer sie in Richtung einer Drehachse 14 aneinander anschlagen.

Über ein Befestigungsmittel 15 hier in Form einer Schraube sind die beiden Codierelemente 10 und 11 dann an der Einschubfach-Wand 6 bzw. an der Einschub-Wand 7 befestigt. Hierzu durchgreift das Befestigungsmittel 15 eine in Richtung der Drehachse 14 verlaufende fensterartige zentrische Aussparung 16 des ersten Codierelementes 10 und eine Durchgangsbohrungen 17 des zweiten Codierelementes 11 sowie eine Durchgangsbohrung 18 bzw. 19 der Einschubfach-Wand 6 bzw. der Einschub-Wand 7. Dabei ist das zweite Codierelement 11 in Form der Codierscheibe mit einer zentralen Senkung 20 versehen, in der der Anschlagkopf 21 der Schraube versenkt ist.

Die Figur 3 zeigt die der Einschubfach-Wand zugewandte Rückseite der Codieranordnung 9. Die Codieranordnung 9 weist zu ihrer Positionierung zwei Positioniermittel 22 in Form von Stiften auf, denen ein Positioniermittel 23 an der Einschubfach-Wand 6 zugeordnet ist.

Gemäß der Figur 4 ist das Positioniermittel 23 an der Einschubfach-Wand ein auf einer Kreisbahn 24 angeordnetes Lochmuster. Die Stifte erstrecken sich dabei in einem vorgegebenen ersten Abstand 25 parallel zur Drehachse 13. Das Lochmuster umfasst zwölf Löcher 26, wobei der Radius der Kreisbahn 24, auf der die Löcher 26 rotationssymmetrisch angeordnet sind, dem vorgegebenen ersten Abstand 25 entspricht. Die Codieranordnung 9 kann somit in zwölf verschiedenen, zu der Drehachse 14 rotationssymmetrischen Stellungen an der Einschubfach-Wand 6 bzw. an der Einschub-Wand 7 positioniert werden.

Gemäß der Figuren 2 und 3 weisen die beiden Codierelemente 10 und 11 Eingriffmittel 27 bzw. 28 auf, die derart zueinander komplementär sind, dass die beiden Codierelemente 10 und 11 in einer aus zumindest zwei verschiedenen, zu der Drehachse 14 rotationssymmetrischen Stellungen in Eingriff miteinander stehen. Als Eingriffsmittel 27 weist das erste Codierelement 10 in Form des äußeren Codierringes die mit acht Ausbuchtungen 29 versehene fensterartige zentrische Aussparung 16 auf.

Das zweite Codierelement 11 in Form der inneren Codierscheibe ist in diese zentrische Aussparung einsetzbar und weist als komplementäres Eingriffsmittel 28 eine Nase auf, die in Abhängigkeit von der gewählten Stellung in eine der acht Ausbuchtungen 29 eingreift.

Somit ist die innere Codierscheibe in acht verschiedenen Stellungen in dem äußeren Codierring positionierbar.

Sowohl das erste Codierelement 10 in Form des äußeren Codierringes als auch das zweite Codierelement 11 in Form der inneren Codierscheibe weisen jeweils zwei zu der Drehachse 14 beabstandete Codiermittel 31, 32 auf. Erste 31 dieser Codiermittel sind als Zapfen ausgebildet, die sich parallel zu der Drehachse 14 erstrecken. Zweite 32 dieser Codiermittel sind als Aussparung ausgebildet.

Die Codiermittel 31 und 32 dienen zur Bildung einer mechanisch codierten Steckverbindung gegenüberliegender Codieranordnungen 9 des Einschubfaches und des Einschubes. Deshalb weisen die Aussparungen einen größeren Durchmesser als die Zapfen auf.

Es ergeben sich 8 x 12 also 96 Codiermöglichkeiten mit jeweils einer einzigen Codieranordnung an dem Einschubfach und an dem Einschub.

Damit kann durch die Integration der inneren Codierscheibe in den äußeren Codierring eine große Anzahl verschiedener Codes auf kleinem Raum realisiert werden. Dies ist insbesondere bei der Codierung von Einschüben, insbesondere von sogenannten Kleineinschüben sehr vorteilhaft, da bei ihnen der Platz zum Anbringen einer Codierung mit ausreichenden Code-Varianten sehr begrenzt ist.

Ist Platz für mehr als eine Codieranordnung 9 vorhanden, so können noch wesentlich mehr Code-Varianten geschaffen werden. Schon durch den Einsatz von je zwei Codieranordnungen 9 erhöht sich die Anzahl der möglichen Codes auf 9216.

Bei den Figuren 1 bis 10 weisen die beiden Codieranordnungen 9 des Einschubfaches 3 und des zugeordneten Einschubes 5 konkordante (einheitliche) Codes auf. Daher kann der Einschub 5 komplett in das Einschubfach 3 eingeschoben werden und die Zapfen der Codierscheibe und des Codierringes des Einschubfaches 3 ragen jeweils in die Aussparungen der gegenüberliegenden Codierscheibe und des gegenüberliegenden Codierringes des Einschubes (vgl. Figur 4).

Damit können die gegenüberliegenden Codieranordnungen des Einschubfaches und des Einschubes so weit ineinander geschoben werden, bis zweite Anschlagflächen 33, 34 der beiden Codierelemente 10, 11 des Einschubes 5, die in einer gemeinsamen, senkrecht zu der Drehachse 14 verlaufenden Ebene liegen, an entsprechenden zweiten Anschlagflächen 33, 34 der beiden Codierelemente des Einschubfaches 3 anschlagen. In dieser Position des Einschubes in dem Einschubfach ist dann im Weiteren auch ein Inbetriebsetzen des Einschubes möglich.

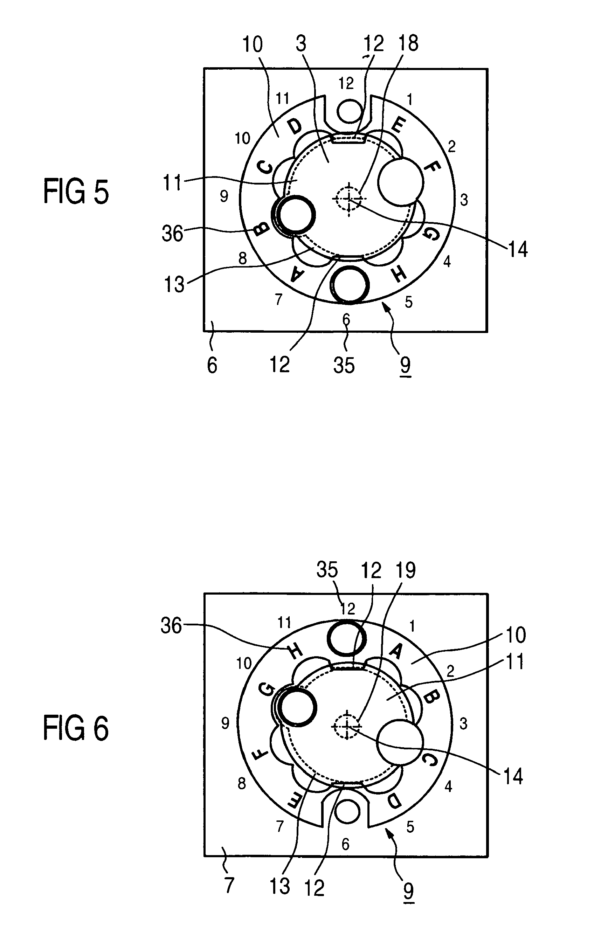

Wird jedoch beispielsweise - wie in Figur 5 dargestellt - der Einschub in ein falsches Fach eingesetzt, so finden die Zapfen nicht die Aussparungen der gegenüberliegenden Codierelemente und der Einschub kann nicht komplett in das Einschubfach eingeschoben werden. Ein Inbetriebsetzen des Einschubes ist dann sicher ausgeschlossen.

Die eingestellten komplementären Codes sind mittels Kennzeichen 35 und 36 in Form von Zahlen und Buchstaben visuell ablesbar, wobei Anzeigemittel auf die Kennzeichen weisen.

Bei der in den Figuren 1 bis 11 dargestellten ersten Ausführungsform der erfindungsgemäßen Codierung dienen die als Zapfen ausgebildeten ersten der Codiermittel 31 zugleich als Anzeigemittel.

So lautet der Code, der in den Figuren 2 bis 5 gezeigten Codieranordnung des Einschubfaches "6 - B". Der konkordante Code des zugeordneten Einschubes gemäß der Figur 6 lautet "12 - G".

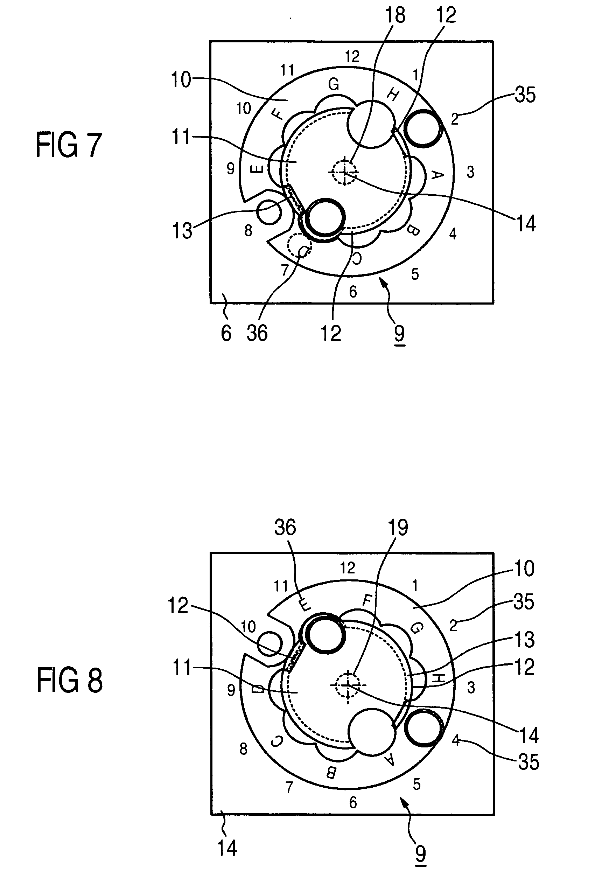

Die Figuren 7 und 8 zeigen ein weiteres Beispiel konkordanter Codes für das Einschubfach und den Einschub. Dabei lautet der Code des Einschubfaches gemäß der Figur 7 "2 - D". Der konkordante Code des Einschubes lautet gemäß der Figur 8 "4 - E".

Sofern also sowohl an dem Einschubfach 3 als auch an dem Einschub 5 und an den daran angeordneten Codieranordnungen 9 die Kennzeichen 35, 36 identisch angeordnet sind, ist zur schnellen Auswahl und Einstellung konkordanter Codes eine Konkordanzliste hilfreich.

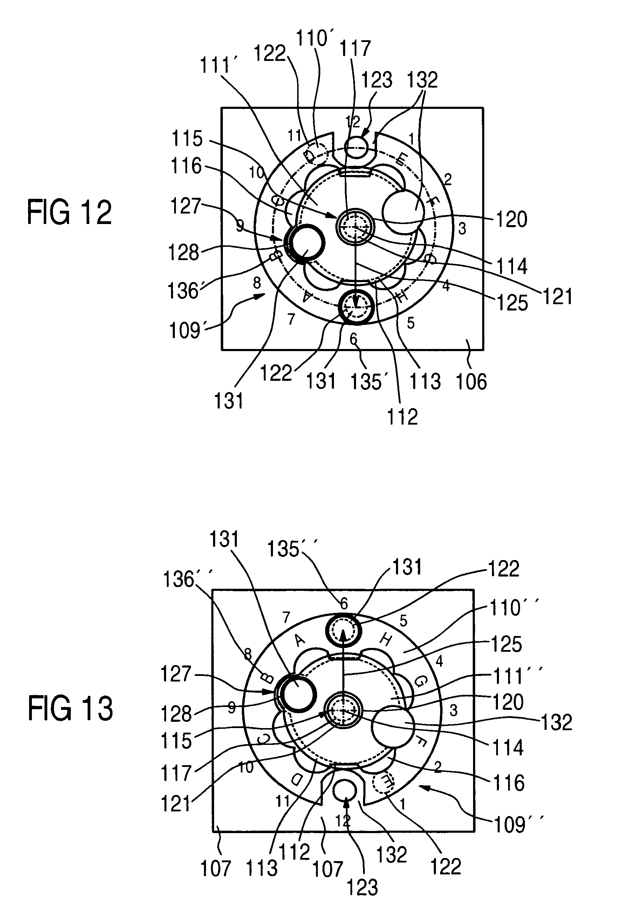

Auch bei der in den Figuren 12 bis 15 dargestellten zweiten Ausführungsform der erfindungsgemäßen Codierung dienen die als Zapfen ausgebildeten ersten der Codiermittel 131 zugleich als Anzeigemittel. Die Kennzeichen 135', 136' an der Einschubfach-Wand 106 und am ersten Codierelement 110', das daran befestigt ist, sind jedoch in Ihrer Anordnung von den Kennzeichen 135", 136" an der Einschub-Wand 107 und am Codierelement 110", das daran befestigt ist, verschieden - und zwar so, dass konkordante Codes auch identisch sind. Zum Einstellen konkordanter Codes am Einschubfach und am Einschub ist bei dieser zweiten Ausführungsform der erfindungsgemäßen Codierung keine Konkordanzliste erforderlich.

So lautet der Code, der in der Figur 12 gezeigten Codieranordnung 109' des Einschubfaches "6 - B". Der konkordante Code der Codieranordnung 109" des zugeordneten Einschubes lautet gemäß der Figur 13 ebenfalls "6 - B".

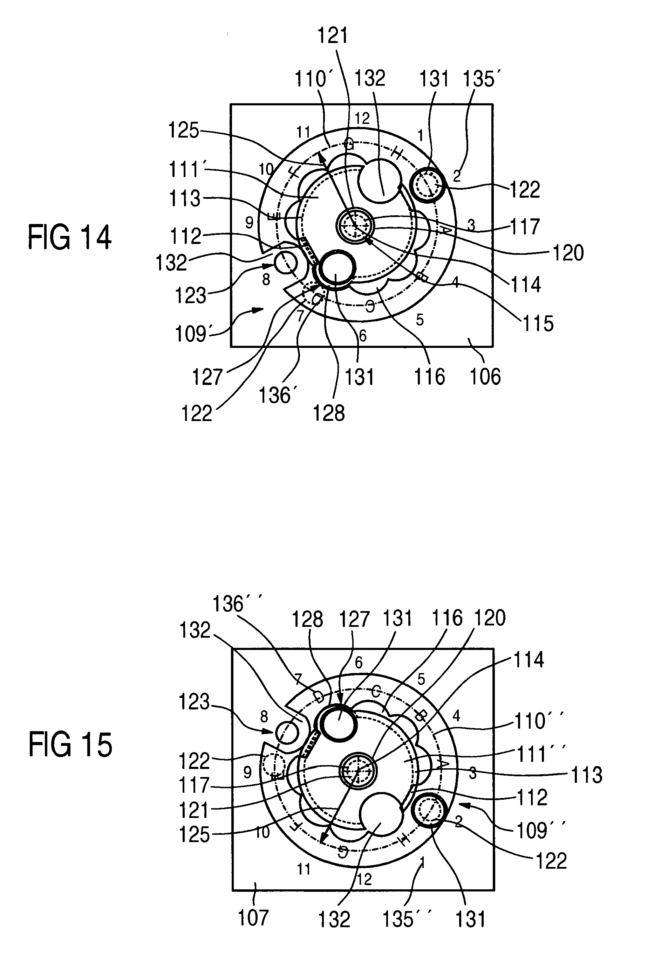

Die Figuren 14 und 15 zeigen ein weiteres Beispiel konkordanter und dabei identischer Codes für das Einschubfach und den Einschub. So lautet der Code des Einschubfaches gemäß der Figur 14 "2 - D". Der konkordante Code des Einschubes lautet gemäß der Figur 15 ebenfalls "2 - D".

Um auch bei der zweiten Ausführungsform der Codierung die Fertigungskosten bei der Herstellung der Codierelemente so gering wie möglich zu halten, ist es von Vorteil, wenn die ersten Codierelemente 110', 110'' und die zweiten Codierelemente 111', 111'' der beiden Codieranordnungen 109', 109'' jeweils ohne Kennzeichen und damit als Gleichteile hergestellt werden. Die Kennzeichen 135', 135'' und 136', 136" können dann später aufgebracht werden. So können beispielsweise Folien aufgeklebt werden, die die Kennzeichen 135', 136' bzw. 135", 136" tragen.

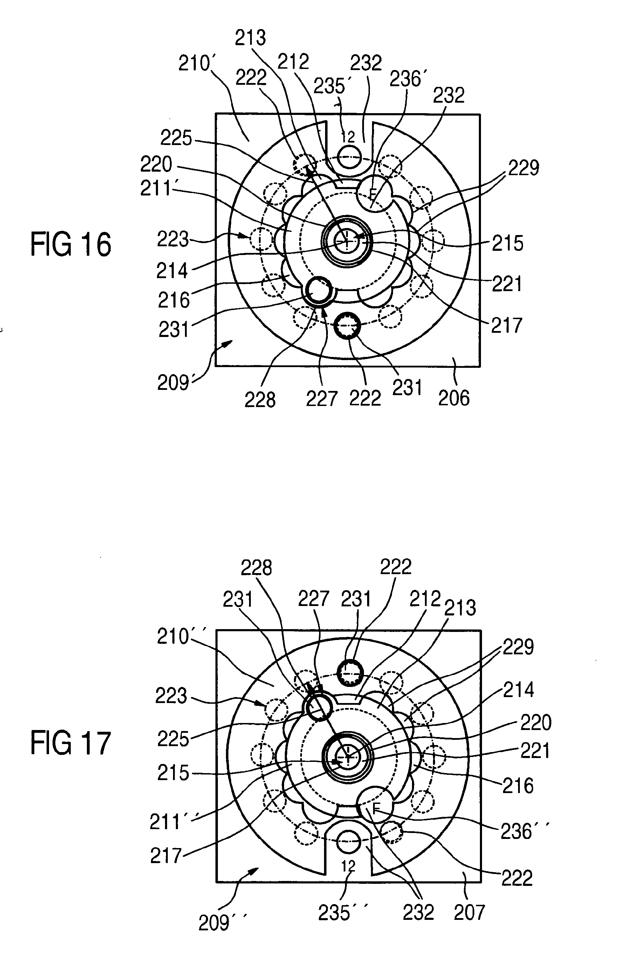

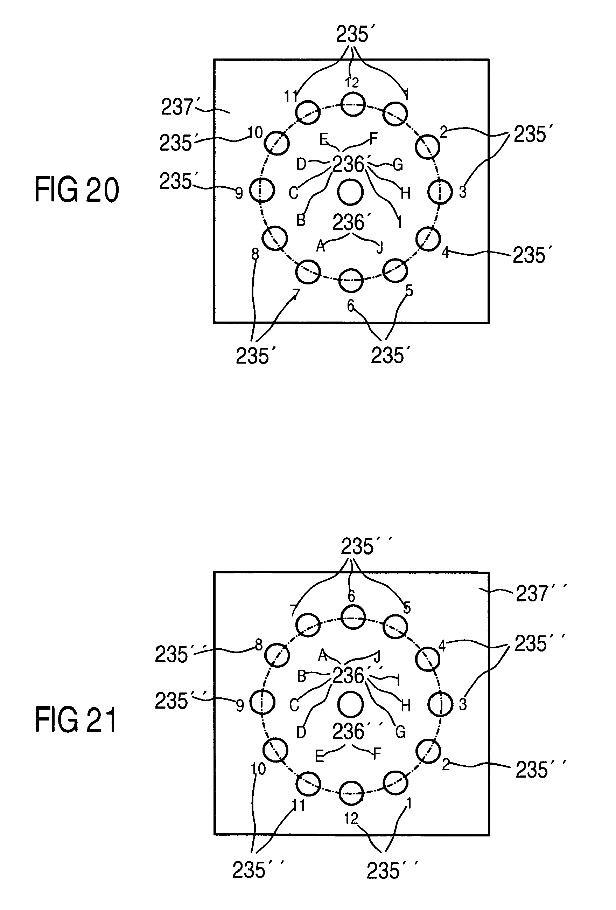

Bei der in den Figuren 16 bis 21 dargestellten dritten Ausführungsform der erfindungsgemäßen Codierung dienen die als Aussparungen ausgebildeten zweiten der Codiermittel 232 zugleich als Anzeigemittel. Die Kennzeichen 235', 236' bzw. 235", 236" sind ausschließlich an der Einschubfach-Wand 206 bzw. an der Einschub-Wand 207 angebracht. Dies kann auch hier beispielsweise durch Folien 237' bzw. 237'' gemäß den Figuren 20 und 21 erfolgen, die an den einander zugewandten Seiten der Einschubfach-Wand und der Einschub-Wand angebracht sind.

Auch bei diesem dritten Ausführungsform der erfindungsgemäßen Kodierung unterscheidet sich die Anordnung der Kennzeichen 235', 236'an der Einschubfach-Wand 206 von der Anordnung der Kennzeichen 235'', 236'' an der Einschub-Wand 207 derart, dass jeweils konkordante Codes auch identisch sind Zum Einstellen konkordanter Codes am Einschubfach und am Einschub ist auch bei dieser dritten Ausführungsform der erfindungsgemäßen Codierung keine Konkordanzliste mehr erforderlich.

So lautet der Code, der in der Figur 16 gezeigten Codieranordnung 209' des Einschubfaches "12 - F". Der konkordante Code der Codieranordnung 209'' des zugeordneten Einschubes lautet gemäß der Figur 17 ebenfalls "12 - F".

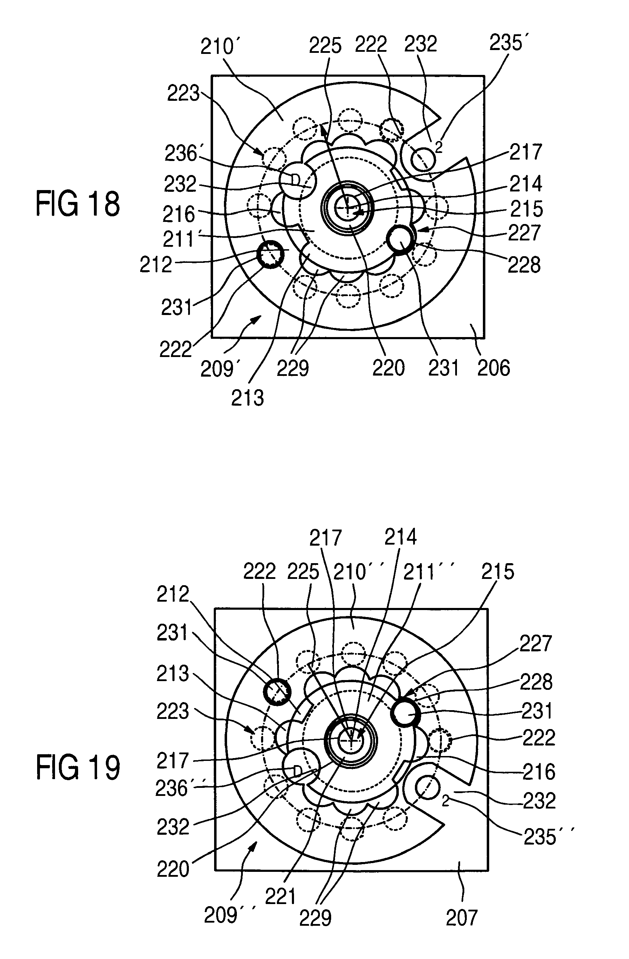

Die Figuren 18 und 19 zeigen ein weiteres Beispiel konkordanter und dabei identischer Codes für das Einschubfach und den Einschub. So lautet der Code des Einschubfaches gemäß der Figur 18 "2 - D". Der konkordante Code des Einschubes lautet gemäß der Figur 19 ebenfalls "2 - D".

## Patentansprüche

1. Codierung für ein erstes Bauteil, dem ein codiertes zweites Bauteil zuzuordnen ist, mit zumindest einer Codieranordnung (9; 109', 109''; 209', 209''),
- bei der die Codieranordnung ein Positioniermittel (22, 122; 222) aufweist, dass zu einem Positioniermittel (23; 123; 223) des ersten Bauteils derart komplementär ist, dass die zumindest eine Codieranordnung an dem ersten Bauteil in einer aus zumindest zwei verschiedenen, zu einer Drehachse (14; 114; 214) rotationssymmetrischen Stellungen an dem ersten Bauteil positionierbar ist, und
- bei der die Codieranordnung zur Schaffung einer codierten Verbindung mit dem zweiten Bauteil zumindest ein Codiermittel (31, 32; 131, 132; 231, 232) aufweist, das durch seine Position den Code der Codieranordnung bestimmt, das zu einem Codiermittel (32, 31; 132, 131, 232, 231) des zweiten Bauteils, dessen Position den Code des zweiten Bauteils bestimmt, komplementär ausgebildet ist und das bei konkordanten Codes der beiden Bauteile eine korrespondierende Stellung zu dem Codiermittel (32, 31; 132, 131, 232, 231) des zweiten Bauteils inne hat, **dadurch gekennzeichnet, dass**
- die Codieranordnung (9; 109',109''; 209', 209'') aus zumindest einem mit dem Positioniermittel (22; 122; 222) versehenen ersten (10; 110', 110''; 210', 210'') und einem zweiten Codierelement (11, 111', 111''; 211', 211'') besteht,
- wobei die beiden Codierelemente Eingriffmittel (27, 28; 127, 128; 227, 228) aufweisen , die derart zueinander komplementär sind, dass die beiden Codierelemente in einer aus zumindest zwei verschiedenen, zu der Drehachse (14; 114; 214) rotationssymmetrischen Stellungen in Eingriff miteinander stehen, und
- wobei jeweils zumindest eines der Codiermittel (31, 32; 131, 132; 231, 232) sowohl an dem ersten und als auch an dem zweiten der Codierelemente vorgesehen ist.

2. Codierung nach Anspruch 1,
**dadurch gekennzeichnet,**
- **dass** das erstes Codierelement (10; 110', 110''; 210', 210'') als Eingriffmittel (27; 127; 227) eine zentrische Aussparung aufweist, die mit zumindest zwei Ausbuchtungen (29; 129; 229) versehen ist und
- **dass** das zweite Codierelement (11, 111', 111''; 211', 211'') in die zentrische Aussparung einsetzbar ist, und als komplementäres Eingriffmittel (28; 128; 208) eine Nase aufweist, die in eine der Ausbuchtungen (29; 129; 229) eingreift.

3. Codierung nach einem der Ansprüche 1 oder 2,
**dadurch gekennzeichnet, dass** zwei oder mehrere der Codieranordnungen (9; 109', 109''; 209', 209") vorgesehen sind.

4. Codierung nach einem der Ansprüche 1 bis 3,
**dadurch gekennzeichnet, dass** als Positioniermittel (22; 122; 222) zumindest ein Stift dient, der sich in einem vorgegebenen ersten Abstand (25; 125; 225) parallel zur Drehachse (14, 114; 214) erstreckt und dem als komplementäres Positioniermittel (23; 123; 223) des ersten Bauteils ein auf einer Kreisbahn (24; 124; 224) angeordnetes Lochmuster zugeordnet ist, wobei der Radius der Kreisbahn dem vorgegebenen ersten Abstand entspricht.

5. Codierung nach einem der Ansprüche 1 bis 4,
**dadurch gekennzeichnet, dass** als Codiermittel (31, 32; 131, 132; 231, 232) an den Codierelementen zumindest ein von der Drehachse (14; 114; 214) beabstandeter Zapfen und/oder zumindest eine von der Drehachse beabstandete Aussparung vorgesehen sind.

6. Codierung nach einem der Ansprüche 1 bis 5,
**dadurch gekennzeichnet, dass** die beiden Codierelemente (10, 11; 110', 110'', 111', 111''; 210', 210'', 211', 211'') erste Anschlagflächen (12, 13; 112', 112'', 113', 113''; 212', 212'', 213', 213'') aufweisen, mittels derer die beiden Codierelemente in Richtung der Drehachse (14; 114; 214) aneinander anschlagen.

7. Codierung nach einem der Ansprüche 1 bis 6,
**dadurch gekennzeichnet, dass** die Codierelemente (10, 11; 110', 110'', 111', 111''; 210', 210'', 211', 211'') zur Aufnahme eines Befestigungsmittels (15; 115; 215) in Richtung der Drehachse (14; 114; 214) mit einer Durchgangsbohrung (18, 19; 118, 119; 218, 219) versehnen sind.

8. Codierung nach Anspruch 7,
**dadurch gekennzeichnet, dass** das Codierelement (11, 111' , 111''; 211', 211''), dessen erste Anschlagfläche (13; 113', 113''; 114, 144'') in Einbaulage dem ersten Bauteil zugewandt ist, mit einer Senkung (20; 120; 220) zur Aufnahme eines Anschlagkopfes (21; 121; 221) des Befestigungsmittels (15; 115; 215) versehen ist.

9. Codierung nach einem der Ansprüche 1 bis 8,
**dadurch gekennzeichnet, dass** das erste, mit dem Positioniermittel (22; 122; 222) versehene Codierelement (10; 110', 110''; 210', 210'') zur visuellen Anzeige seiner ausgewählten Stellung am ersten Bauelement ein erstes Anzeigemittel aufweist.

10. Codierung nach einem der Ansprüche 1 bis 9,
**dadurch gekennzeichnet, dass** das zweite Codierelement (11, 111', 111''; 211', 211'') zur visuellen Anzeige seiner ausgewählten Stellung gegenüber dem ersten Codierelement (10; 110', 110''; 210', 210 ") ein zweites Anzeigemittel aufweist.

11. Codierung nach Anspruch 10,
**dadurch gekennzeichnet, dass** das erste Codierelement (10; 110', 110'') mit Kennzeichen (36; 136', 136'') versehen ist, die dem zweiten Anzeigemittel zugeordneten sind, wobei das zweite Anzeigemittel zur visuellen Anzeige der ausgewählten Stellung des zweiten Codierelementes auf eines der Kennzeichen (36; 136', 136'') weist.

12. Codierung nach einem der Ansprüche 9 bis 11,
**dadurch gekennzeichnet, dass** jeweils zumindest eines (31; 131', 131''; 132', 132'') der Codiermittel des ersten Codierelementes als erstes Anzeigemittel und jeweils zumindest eines (31; 131', 131''; 132', 132'') der Codiermittel des zweiten Codierelementes als zweites Anzeigemittel dient.

13. Codierung nach einem der Ansprüche 11 oder 12,
**dadurch gekennzeichnet, dass** die dem zweiten Anzeigemittel zugeordneten Kennzeichen (36; 136', 136''; 236', 236'') Buchstaben oder Zahlen sind.

14. Einschubanordnung (2) eines elektrischen Schaltfeldes (1) mit einem Einschubfach (3) und einem Einschub (5),
bei der das Einschubfach (3) und der Einschub (5) mit einander zugeordneten Codierungen (8) versehen sind und bei der der Einschub (5) nur dann in eine betriebsfähige Stellung in das Einschubfach (3) einschiebbar ist, wenn die beiden Codierungen (8) einen übereinstimmenden Code aufweisen,
**dadurch gekennzeichnet, dass** die Codierung (8) an dem Einschubfach und/oder die Codierung (8) an dem Einschub nach einem der Ansprüche 1 bis 13 ausgebildet sind.

15. Einschubanordnung (2) nach Anspruch 14,
**dadurch gekennzeichnet, dass** das Einschubfach (3) und/oder der Einschub (5) mit dem ersten Anzeigemittel zugeordneten Kennzeichen (35; 135', 135''; 235', 235'') versehen sind, wobei das erste Anzeigemittel zur visuellen Anzeige der ausgewählten Stellung des ersten Codierelementes auf eines dieser Kennzeichen weist.

16. Einschubanordnung nach Anspruch 15,
**dadurch gekennzeichnet, dass** die dem ersten Anzeigemittel zugeordneten Kennzeichen (35; 135', 135''; 235', 235'') Buchstaben oder Zahlen sind.

## Claims

1. Coding for a first component, with which a coded second component can be associated, having at least one coding arrangement (9; 109', 109''; 209', 209'') ,
- in which the coding arrangement has a positioning means (22, 122; 222), which is complementary to a positioning means (23; 123; 223) of the first component such that the at least one coding arrangement on the first component can be positioned in one of at least two different positions on the first component which are rotationally symmetrical with respect to a rotation axis (14; 114; 214), and
- in which the coding arrangement has at least one coding means (31, 32; 131, 132; 231, 232) in order to provide a coded connection to the second component, which coding means (31, 32; 131, 132; 231, 232) determines the code of the coding arrangement by its position and is designed to be complementary to a coding means (32, 31; 132, 131, 232, 231) on the second component, whose position determines the code of the second component, and which intrinsically has a position corresponding to the coding means (32, 31; 132, 131, 232, 231) of the second component when the codes of the two components are concordant,
**characterized in that**
- the coding arrangement (9; 109', 109"; 209', 209") comprises at least one first coding element (10; 110', 110''; 210', 210''), which is provided with the positioning means (22; 122; 222), and a second coding element (11, 111', 111''; 211', 211"),
- wherein the two coding elements have engagement means (27, 28; 127, 128; 227, 228) which are complementary to one another such that the two coding elements engage with one another in one of at least two different positions which are rotationally symmetrical with respect to the rotation axis (14; 114; 214), and
wherein in each case at least one of the coding means (31, 32; 131, 132; 231, 232) is provided both on the first and on the second of the coding elements.

2. Coding according to Claim 1,
**characterized**
- **in that** the first coding element (10; 110', 110''; 210', 210'') has a central cutout as engagement means (27; 127; 227), which is provided with at least two outward bulges (29; 129; 229), and
- **in that** the second coding element (11, 111', 111''; 211', 211'') can be inserted into the central cutout and has a tab as complementary engagement means (28; 128; 208), which engages in one of the outward bulges (29; 129; 229).

3. Coding according to one of claims 1 or 2,
**characterized in that**
two or more of the coding arrangements (9; 109', 109''; 209', 209'') are provided.

4. Coding according to one of Claims 1 to 3,
**characterized in that**
at least one pin is used as positioning means (22; 122; 222) and extends parallel to the rotation axis (14, 114; 214) at a predetermined first distance (25; 125; 225), and a hole pattern which is arranged on a circular path (24; 124; 224) is associated therewith as complementary positioning means (23; 123; 223) of the first component, wherein the radius of the circular path corresponds to the predetermined first distance.

5. Coding according to one of Claims 1 to 4,
**characterized in that**
at least one peg, which is at a distance from the rotation axis (14; 114; 214), and/or at least one cutout, which is at a distance from the rotation axis, are/is provided as coding means (31, 32; 131, 132; 231, 232) on the coding elements.

6. Coding according to one of Claims 1 to 5,
**characterized in that**
the two coding elements (10, 11; 110', 110'', 111', 111''; 210', 210'', 211', 211'') have first stop surfaces (12, 13; 112', 112'', 113', 113''; 212', 212'', 213', 213"), by means of which the two coding elements impact on one another in the direction of the rotation axis (14; 114; 214).

7. Coding according to one of Claims 1 to 6,
**characterized in that**
the coding elements (10, 11; 110', 110'', 111', 111''; 210', 210'', 211', 211'') are intended to hold an attachment means (15; 115; 215) in the direction of the rotation axis (14; 114; 214) with a through-hole (18, 19; 118, 119; 218, 219).

8. Coding according to Claim 7,
**characterized in that**
the coding element (11, 111', 111''; 211', 211'') whose first stop surface (13; 113', 113''; 114, 144'') faces the first component in the installed position, is provided with a recess (20; 120; 220) for holding a stop head (21; 121; 221) of the attachment means (15; 115; 215).

9. Coding according to one of Claims 1 to 8,
**characterized in that**
the first coding element (10; 110', 110''; 210', 210''), which is provided with the positioning means (22; 122; 222), has a first indication means for visual indication of its selected position on the first component.

10. Coding according to one of Claims 1 to 9,
**characterized in that**
the second coding element (11, 111', 111''; 211', 211'') has a second indication means for visual indication of its selected position with respect to the first coding element (10; 110', 110''; 210', 210'').

11. Coding according to Claim 10,
**characterized in that**
the first coding element (10; 110', 110'') is provided with identifications (36; 136', 136'') which are associated with the second indication means, wherein the second indication means points to one of the identifications (36; 136', 136'') for visual indication of the selected position of the second coding element.

12. Coding according to one of Claims 9 to 11,
**characterized in that**
at least one (31; 131', 131''; 132', 132'') of the coding means of the first coding element is in each case used as first indication means, and at least one (31; 131', 131''; 132', 132'') of the coding means of the second coding element is in each case used as second indication means.

13. Coding according to one of Claims 11 or 12,
**characterized in that**
the identifications (36; 136', 136''; 236', 236'') which are associated with the second indication means are letters or numbers.

14. Insert arrangement (2) of an electrical switchboard (1) having an insert compartment (3) and an insert (5), in which the insert compartment (3) and the insert (5) are provided with mutually associated codings (8), and in which the insert (5) can be inserted into the insert compartment (3) in an operable position only if the two codings (8) have a matching code,
**characterized in that**
the coding (8) on the insert compartment and/or the coding (8) on the insert are/is according to one of Claims 1 to 13.

15. Insert arrangement (2) according to Claim 14,
**characterized in that**
the insert compartment (3) and/or the insert (5) are/is provided with identifications (35; 135', 135''; 235', 235'') associated with the first indication means, wherein the first indication means points to one of these identifications for visual indication of the selected position of the first coding element.

16. Insert arrangement according to Claim 15,
**characterized in that**
the identifications (35; 135', 135''; 235', 235'') associated with the first indication means are letters or numbers.

## Revendications

1. Codage pour un premier élément, qui est associé à un deuxième élément codé, comprenant au moins un dispositif ( 9 ; 109', 109" ; 209', 209" ) de codage,
- dans lequel le dispositif de codage a un moyen ( 22 ; 122 ; 222 ) de mise en position, qui est complémentaire d'un moyen ( 23 ; 123 ; 223 ) de mise en position du premier élément, de manière à ce que le au moins un dispositif de codage sur le premier élément puisse être mis en position sur le premier élément dans l'une d'au moins deux positions différentes symétriques en rotation par rapport à un axe ( 14 ; 114 ; 214 ) de rotation, et
- dans lequel le dispositif de codage a, pour ménager une liaison codée avec le deuxième élément, au moins un moyen ( 31, 32 ;131, 132 ; 231, 232 ) de codage, qui détermine par sa position le code du dispositif de codage, qui est formé de manière complémentaire d'un moyen ( 32, 31 ; 132, 131, 232, 231 ) de codage du deuxième élément, dont la position détermine le code du deuxième élément, et qui, pour des codes concordants des deux éléments, possède une position correspondante au moyen ( 32, 31 ; 132, 131, 232, 231 ) de codage du deuxième élément, **caractérisé en ce que**
- le dispositif ( 9 ; 109', 109" ; 209', 209") de codage est constitué d'au moins un premier élément ( 10 ; 110', 110" ; 210', 210" ) de codage muni du moyen ( 22 ; 122 ; 222 ) de mise en position et d'un deuxième élément ( 11, 111', 111" ; 211', 211" ) de codage,
- dans lequel les deux éléments de codage ont des moyens ( 27, 28 ; 127, 128 ; 227, 228 ) de pénétration, qui sont complémentaires les uns des autres, de manière à ce que les deux éléments de codage soient en prise entre eux dans l'une d'au moins deux positions différentes symétriques en rotation par rapport à l'axe ( 14 ; 114 ; 214 ) de rotation, et
- dans lequel, respectivement, au moins l'un des moyens ( 31, 32 ;131, 132 ; 231, 232 ) de codage est prévu à la fois sur le premier et sur le deuxième éléments de codage.

2. Codage suivant la revendication 1,
**caractérisé**
- **en ce que** le premier élément ( 10 ; 110', 110" ; 210', 210" ) de codage a comme moyen ( 27 ; 127 ; 227 ) de pénétration un évidement centré, qui est muni de deux indentations ( 29 ; 129 ; 229 ) et
- **en ce que** le deuxième élément ( 11 ; 111', 111" ; 211', 211" ) de codage peut être inséré dans l'évidement centré et comme moyen ( 28 ; 128 ; 208 ) complémentaire de pénétration a un bec, qui pénètre dans l'une des indentations ( 29 ; 129 ; 229 ) .

3. Codage suivant l'une des revendications 1 ou 2,
**caractérisé en ce que**
il est prévu deux ou plusieurs des dispositifs ( 9 ; 109', 109" ; 209', 209" ) de codage.

4. Codage suivant l'une des revendications 1 à 3,
**caractérisé en ce que**
sert de moyen ( 22 ; 122 ; 222 ) de mise en position au moins une broche, qui s'étend parallèlement à l'axe ( 14 ; 114 ; 214 ) de rotation à une première distance ( 25 ; 125 ; 225 ) prescrite, et à laquelle est associé comme moyen ( 23 ; 123 ; 223 ) complémentairs de mise en position du premier élément un modèle de trou disposé sur une trajectoire ( 24 ; 124 ; 224 ), le rayon de la trajectoire correspondant à la première distance prescrite.

5. Codage suivant l'une des revendications 1 à 4,
**caractérisé en ce que**
il est prévu comme moyen ( 31, 32 ; 131, 132 ; 231, 232 ) de codage sur les éléments de codage au moins un tourillon à distance de l'axe ( 14 ; 114 ; 214 ) de rotation et/ou au moins un évidement à distance de l'axe de rotation.

6. Codage suivant l'une des revendications 1 à 5,
**caractérisé en ce que**
les deux éléments ( 10, 11 ; 110', 110" ; 111', 111" ; 210', 210" ; 211', 211" ) de codage ont des premières surfaces ( 12, 13 ; 112', 112" ; 113', 113" ; 212', 212" ; 213', 213" ) de butée, au moyen desquelles les deux éléments de codage butent l'un contre l'autre dans la direction de l'axe ( 14 ; 114 ; 214 ).

7. Codage suivant l'une des revendications 1 à 6,
**caractérisé en ce que**
les éléments ( 10, 11 ; 110', 110" ; 111', 111" ; 210', 210" ; 211', 211" ) de codage sont munis, pour la réception d'un moyen ( 15 ; 115 ; 215 ) de fixation dans la direction de l'axe ( 14 ; 114 ; 214 ) de rotation, d'un alésage ( 18, 19 ; 118, 119 ; 218, 219 ) traversant.

8. Codage suivant la revendication 7,
**caractérisé en ce que**
l'élément ( 11 ; 111', 111" ; 211', 211" ) de codage, dont la première surface (13 ; 113', 113" ; 114', 114" ) de butée est dans une position de montage tournée vers le premier élément, est muni d'un creux ( 20 ; 120 ; 220 ) de réception d'une tête ( 21 ; 121 ; 221 ) de butée du moyen ( 15 ; 115 ; 215 ) de fixation.

9. Codage suivant l'une des revendications 1 à 8,
**caractérisé en ce que**
le premier élément ( 10 ; 110', 110" ; 210', 210" ) de codage muni du moyen ( 22 ; 122 ; 222 ) de mise en position a un premier moyen d'indication pour l'indication visuelle de sa position sélectionnée sur le premier élément.

10. Codage suivant l'une des revendications 1 à 9,
**caractérisé en ce que**
le deuxième élément ( 11 ; 111', 111" ; 211', 211" ) de codage a un deuxième moyen d'indication pour l'indication visuelle de sa position sélectionnée par rapport au premier élément ( 10 ; 110', 110" ; 210', 210" ) de codage.

11. Codage suivant la revendication 10,
**caractérisé en ce que**
le premier élément ( 10 ; 110', 110" ) de codage est muni de caractéristiques ( 36 ; 136', 136" ), qui sont associées au deuxième moyen d'indication, le deuxième moyen d'indication étant, pour l'indication visuelle de la position sélectionnée du deuxième élément de codage, tourné vers l'une des caractéristiques ( 36 ; 136' ; 136" ).

12. Codage suivant l'une des revendications 9 à 11,
**caractérisé en ce que**
respectivement au moins l'un ( 31 ; 131', 131" ; 132', 132" ) des moyens de codage du premier élément de codage sert de premier moyen d'indication et respectivement au moins l'un ( 31 ; 131', 131" ; 132', 132" ) des moyens de codage du deuxième élément de codage sert de deuxième moyen d'indication.

13. Codage suivant l'une des revendications 11 ou 12,
**caractérisé en ce que**
les caractéristiques ( 36 ; 136', 136" ; 236', 236" ) associées au deuxième moyen d'indication sont des lettres ou des nombres.

14. Dispositif ( 2 ) enfichable d'un panneau ( 1 ) électrique de couplage, comprenant un casier ( 3 ) et un tiroir ( 5 ), dans lequel le casier ( 3 ) et le tiroir ( 5 ) sont munis de codages ( 8 ) associés l'un à l'autre et dans lequel le tiroir ( 5 ) ne peut être inséré dans le casier ( 3 ) dans une position apte au fonctionnement que si les deux codages ( 8 ) ont un code en coïncidence,
**caractérisé en ce que**
le codage ( 8 ) sur le casier et/ou le codage ( 8 ) sur le tiroir sont constitués suivant l'une des revendications 1 à 13.

15. Dispositif ( 2 ) enfichable suivant la revendication 14,
**caractérisé en ce que**
le casier ( 3 ) et/ou le tiroir ( 5 ) sont munis de caractéristiques ( 35 ; 135', 135" ; 235', 235" ) associées au premier moyen d'indication, le premier moyen d'indication indiquant l'une de ses caractéristiques pour l'indication visuelle de la position sélectionnée du premier élément de codage.

16. Dispositif suivant la revendication 15,
**caractérisé en ce que**
les caractéristiques ( 35 ; 135', 135" ; 235', 235" ) associées au premier moyen d'indication sont des lettres ou des nombres.
